# EUROPEAN PATENT APPLICATION

(11) **EP 4 495 626 A1**
(43) Date of publication of application: **22.01.2025**
(21) Application number: 23770187.5
(22) Date of filing: 10.02.2023
(51) Int. Cl.: G01S 7/4861, G01C 3/06, G01S 7/4865, G01S 17/10, G01S 17/931

(54) **DISTANCE MEASUREMENT DEVICE AND ONBOARD DEVICE**

(30) Priority: 14.03.2022 JP 2022038872
(71) Applicant: Sony Group Corporation, Tokyo 108-0075 (JP)
(72) Inventor: ONO, Tomoki, Tokyo 108-0075 (JP)
(74) Representative: MFG Patentanwälte Meyer-Wildhagen Meggle-Freund Gerhard PartG mbB
(86) International application number: PCT/JP2023/004506
(87) International publication number: WO 2023/176226

(57) **Abstract**

One of objects of the present disclosure is to provide a distance measuring device capable of extending the range of measurable distance. Provided by the present disclosure is a distance measuring device (1000) that includes a light-receiving element (104), an extraction section (106), an amplification section (110), and at least three comparators (first comparator 111, second comparator 112, and third comparator 113). The light-receiving element (104) is able to achieve single-photon detection and generates an analog output that varies with the number of simultaneously received photons. The extraction section (106) extracts high-frequency components of an output of the light-receiving element. The amplification section (110) amplifies an output of the extraction section. The first comparator 111, the second comparator 112, and the third comparator 113 receive supply of an output from the amplification section and have different threshold voltages (first threshold voltage 141, second threshold voltage 142, and third threshold voltage 143). The threshold voltage (third threshold voltage 143) set for a predetermined comparator (third comparator 113) is a threshold voltage (Vth1) corresponding to single-photon detection in at least a part of a measurement period. The distance measuring device (1000) corrects a provisional time lag so as to cancel a time walk error.

## Description

### [Technical Field]

The present disclosure relates to a distance measuring device and a vehicle-mounted device.

### [Background Art]

A distance measurement system for measuring the distance to a distance measurement target (hereinafter may be abbreviated as the target) is disclosed in NPL 1 and NPL 2 below.

### [Citation List]

### [Patent Literature]

[NPL 1]
   Remote Sens. 2016, 8, 958
[NPL 2]
   Georg Kirchner and Franz Koidl 1999 J. Opt. A: Pure Appl. Opt. 1 163

### [Summary]

### [Technical Problem]

In the field described above, it is desirable to extend a range of distance measurable by distance measuring devices.

One of objects of the present disclosure is to provide a distance measuring device capable of extending the range of measurable distance and a vehicle-mounted device including such a distance measuring device.

### [Solution to Problem]

According to an aspect of the present disclosure, there is provided a distance measuring device that includes, for example, a light-receiving element, an extraction section, an amplification section, and at least three comparators. The light-receiving element is able to achieve single-photon detection and that generates an analog output that varies with the number of simultaneously received photons. The extraction section extracts high-frequency components of an output of the light-receiving element. The amplification section amplifies an output of the extraction section. The comparators receive supply of an output from the amplification section and have different threshold voltages. The threshold voltage set for a predetermined one of the comparators is a threshold voltage corresponding to single-photon detection in at least a part of a measurement period.

According to another aspect of the present disclosure, there is provided a vehicle-mounted device that includes the above-described distance measuring device.

### [Brief Description of Drawings]

[FIG. 1]

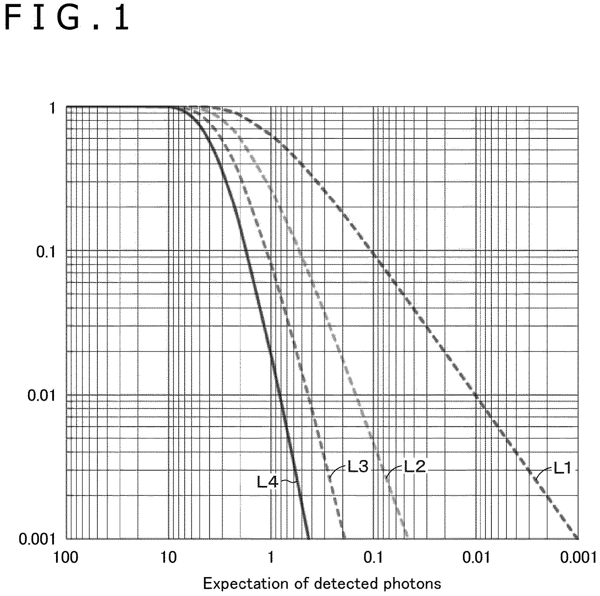

   FIG. 1 is a diagram illustrating an example of a relation between an expected value of the number of photons according to a Poisson distribution and probability of detection.
[FIG. 2]

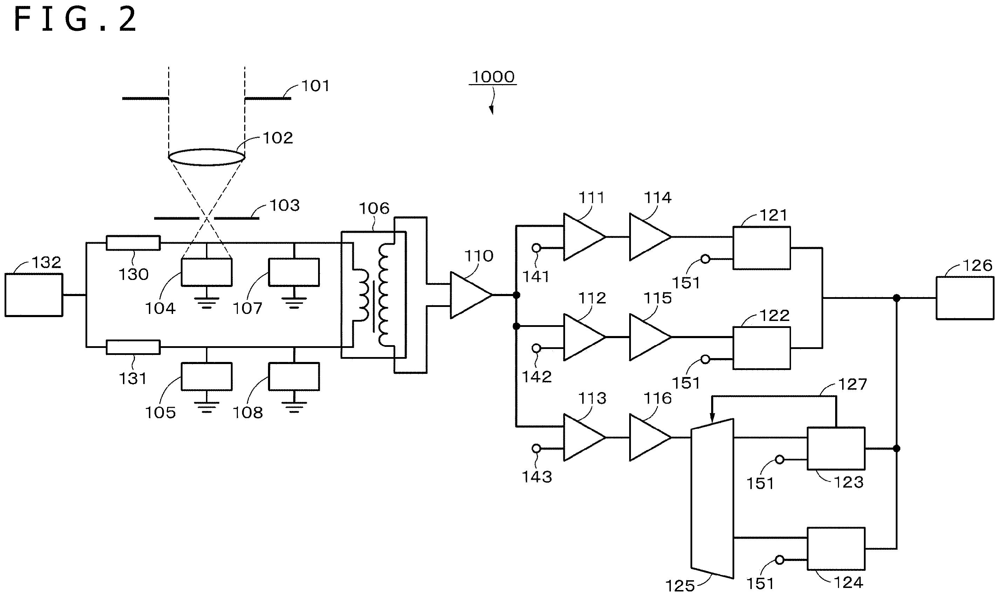

   FIG. 2 is a diagram illustrating an example of the configuration of a distance measuring device according to an embodiment of the present disclosure.
[FIG. 3]

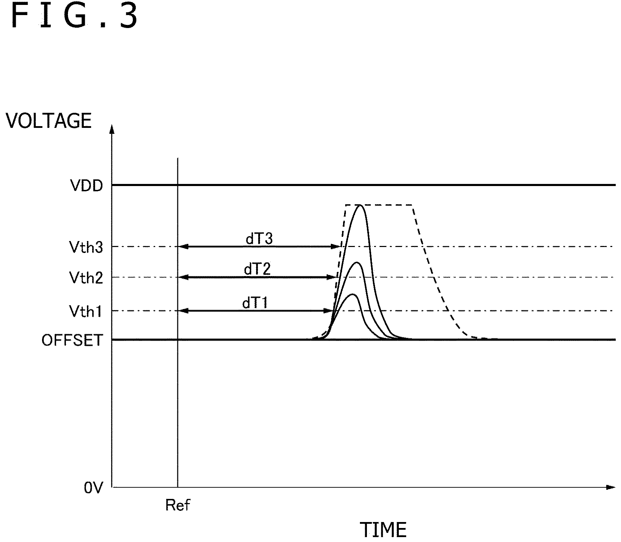

   FIG. 3 is a diagram illustrating an example of a time lag and the like from measurement signals.
[FIG. 4]

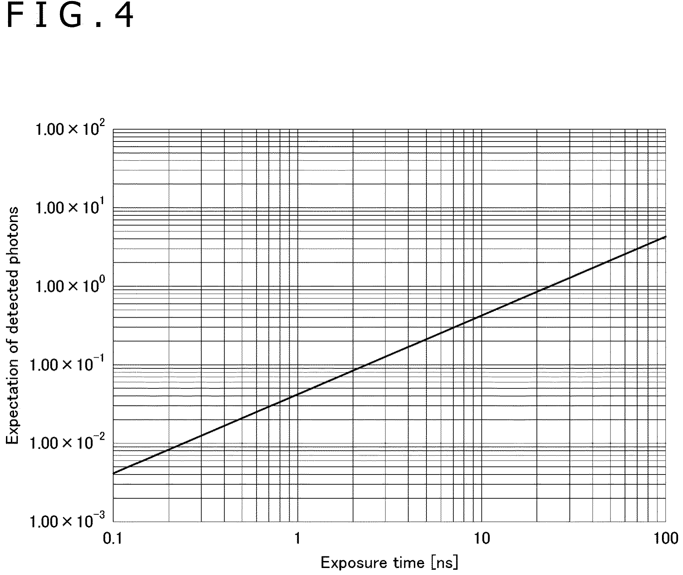

   FIG. 4 is a diagram illustrating an example of a relation between exposure time and the expected value of the number of photons received by a light-receiving element in a 10,000-lux environment.
[FIG. 5]

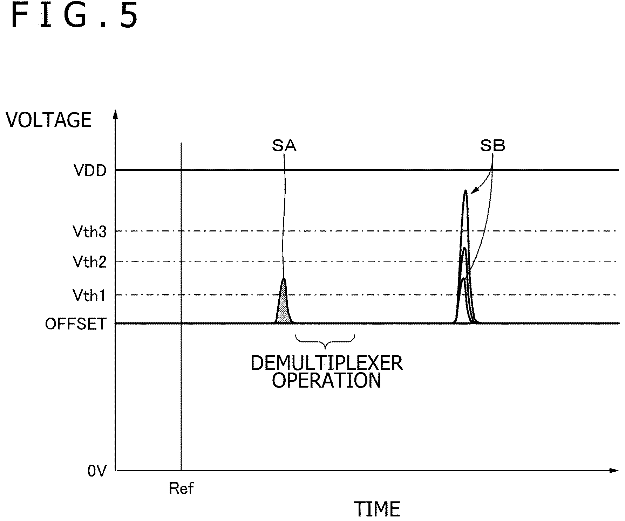

   FIG. 5 is a diagram that is referenced to describe an example of a demultiplexer operation according to the embodiment of the present disclosure.
[FIG. 6]

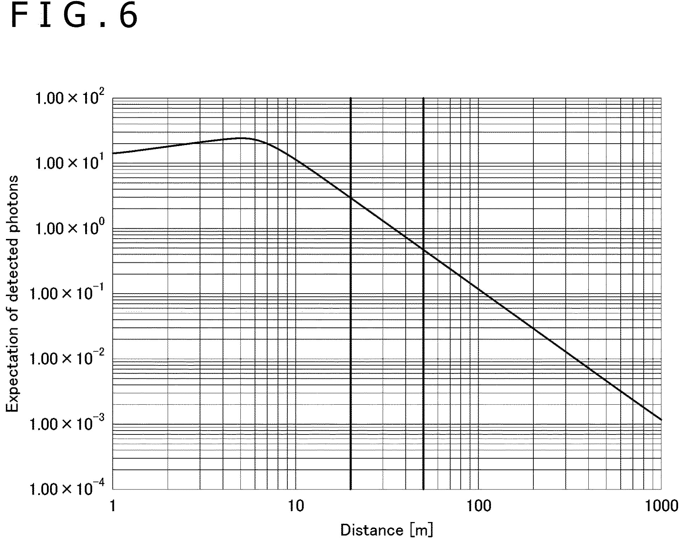

   FIG. 6 is a diagram illustrating an example of a relation between the distance to a distance measurement target and the expected value of the number of photons received by the light-receiving element.
[FIG. 7]

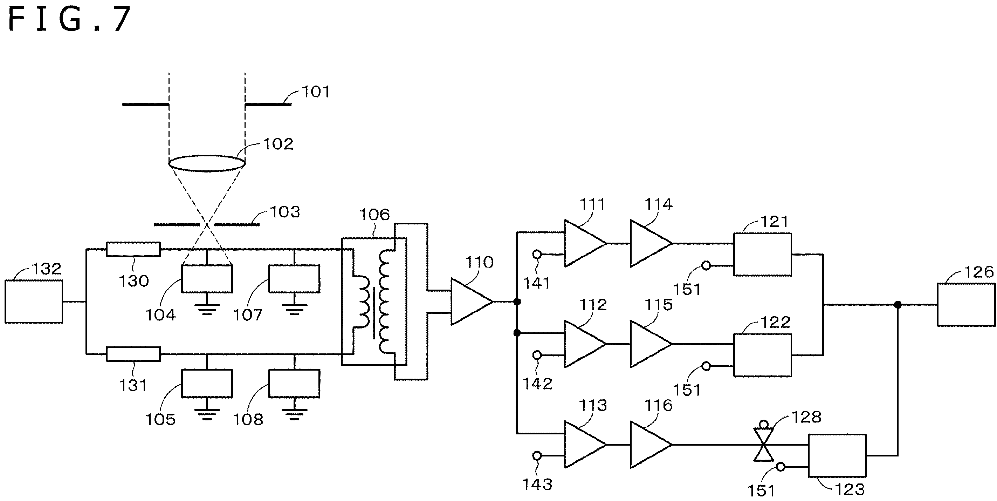

   FIG. 7 is a diagram illustrating another example of the configuration of the distance measuring device.
[FIG. 8]

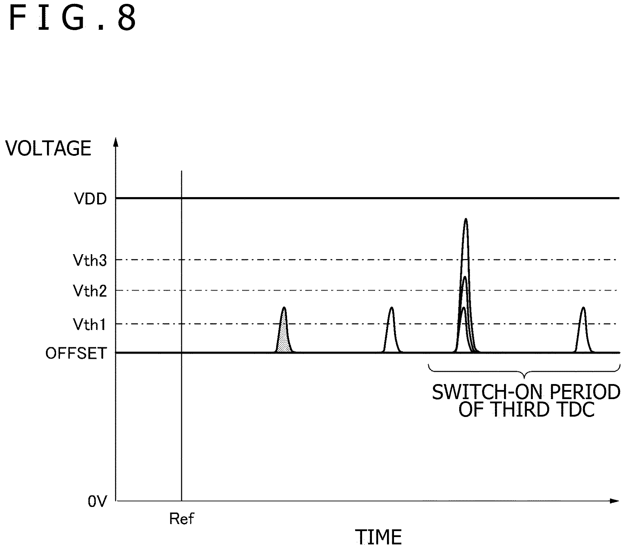

   FIG. 8 is a diagram that is referenced to describe an example of the operation of a switch included in the distance measuring device.
[FIG. 9]

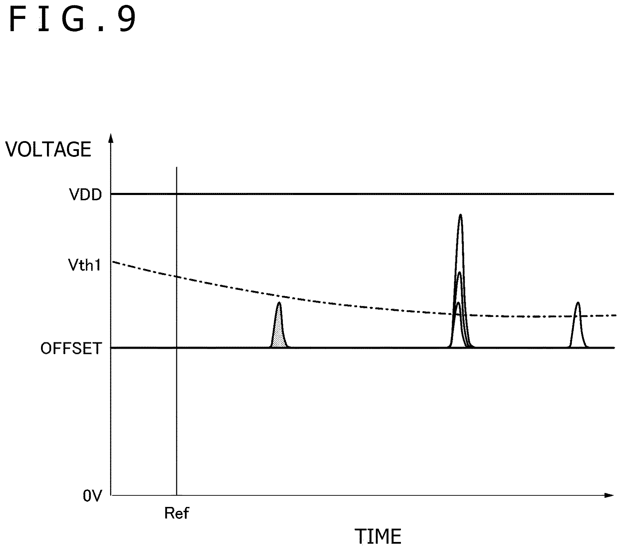

   FIG. 9 is a diagram for describing an example in which a threshold voltage is modulated.
[FIG. 10]

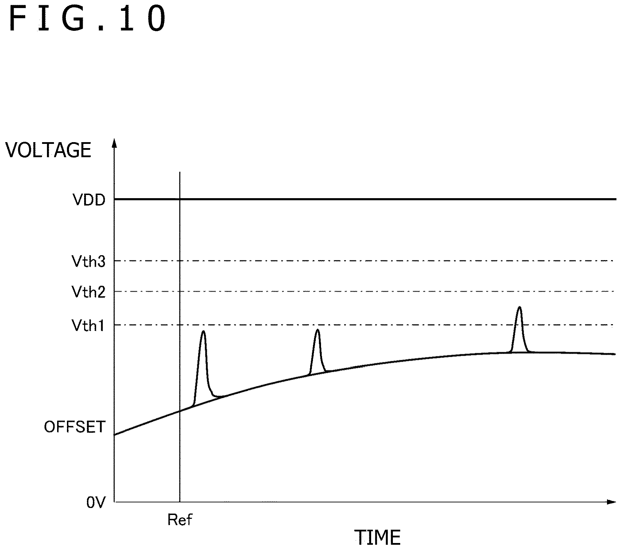

   FIG. 10 is a diagram for describing an example in which an offset is modulated.
[FIG. 11]

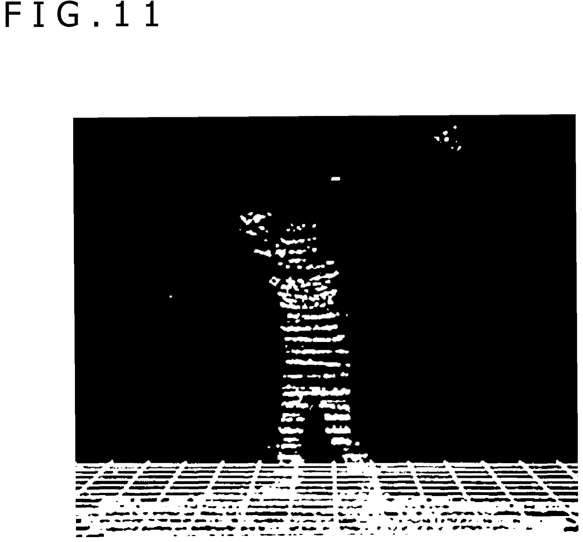

   FIG. 11 is a diagram that is referenced to describe examples of application.
[FIG. 12]

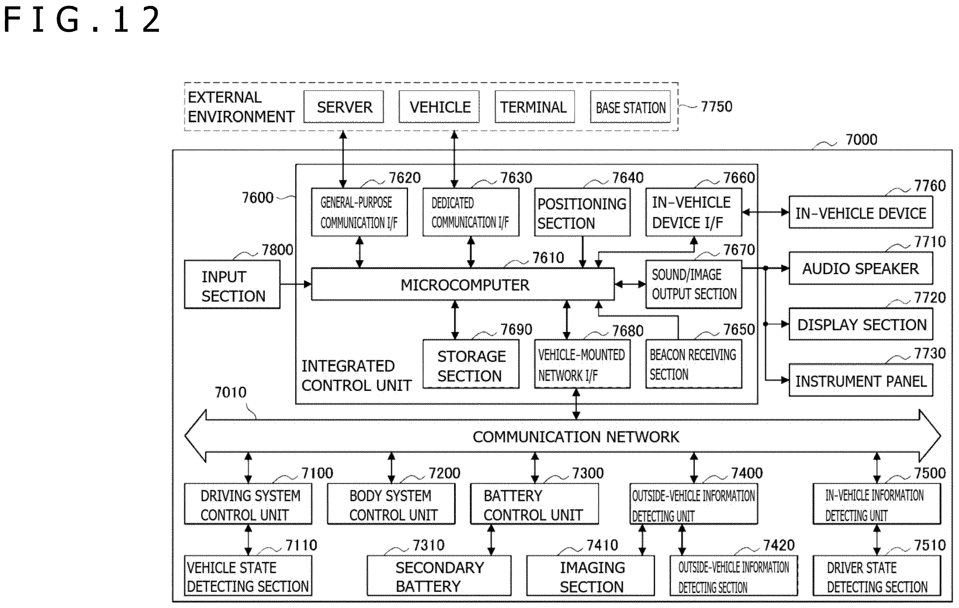

   FIG. 12 is a block diagram depicting an example of schematic configuration of a vehicle control system.
[FIG. 13]

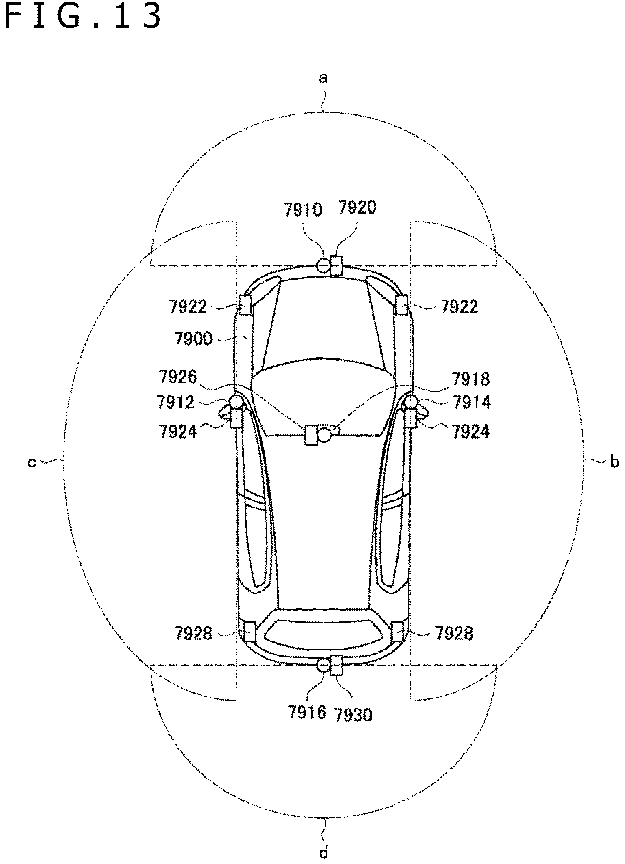

   FIG. 13 is a diagram of assistance in explaining an example of installation positions of an outside-vehicle information detecting section and an imaging section.

### [Description of Embodiment]

An embodiment and the like of the present disclosure will now be described with reference to the accompanying drawings. Note that the description will be given in the following order.

### <Background of Present Disclosure>

### <Embodiment>

### <Modifications>

### <Examples of Application>

The embodiment and the like described below are a preferred specific embodiment of the present disclosure, and the contents of the present disclosure are not limited to the embodiment and the like described below. It should be noted that, in the following description, component elements having substantially the same functional configuration are designated by the same reference signs to omit their redundant description as appropriate. Further, in order to prevent the illustrations from becoming complicated, only some of the component elements may be given the reference signs, or the illustrations may be simplified, enlarged, or reduced.

### <Background of Present Disclosure>

First, the background of the present disclosure will be described to facilitate the understanding of the present disclosure. Distance sensors based on the time-of-flight measurement method (hereinafter referred to as TOF (Time of Flight) as appropriate) are used in a wide variety of applications, such as topographic measurement, structure management, autonomous navigation, and production line defect inspection. A pulse width of a laser provides a measurable time resolution. Since a speed of light is constant, the laser pulse width contributes to the resolution of distance measurement. For example, in a case where the speed of light is 3 × 10⁸ m/s, the distance resolution is 15 cm when the time resolution is 1 nanosecond, and 0.15 mm when the time resolution is 1 picosecond.

Highly accurate distance sensors are expected to be used also in the field of entertainment, such as sports, movie shooting, and art. For example, when a form is to be checked in sports applications, it is necessary to acquire dense point cloud data at a high frame rate. Therefore, the frame rate and point cloud density of existing LiDAR (Light Detection and Ranging) are insufficient. In a case of movie shooting, an actual object is converted into a huge amount of point cloud data and virtually reconstructed. Accordingly, the time required for point cloud data acquisition and reconstruction is reflected in the cost. Consequently, the required point cloud density is 100 times or more that of existing LiDAR, and the required distance accuracy is on the order of millimeters. One factor limiting the maximum point cloud density of LiDAR is laser safety, so that systems are built with laser output compliant with Laser Safety Class 1. Further, depending on the adopted LiDAR method, multiple shots are statistically processed to increase distance accuracy or reduce the influence, for example, of sunlight. This results in decreasing the point cloud density.

In order to increase the point cloud density, it is necessary to increase efficiency of use of laser light emitted from a LiDAR system. Specifically, the lower the laser output required to acquire the position information of a single point, the higher the point cloud density, and thus the higher the frame rate achievable by LiDAR. A space-based LiDAR system mounted on an artificial satellite uses a method called SPL (Single Photon LiDAR) to acquire point cloud data by irradiating the ground with pulsed laser light and receiving only two to ten photons reflected. Further, since the point cloud data can be acquired by a single shot, the terrain can be measured from the artificial satellite orbiting the earth at a speed of 7 km/sec. Similarly, the method is also used to measure the terrain from an airplane (refer, for example, to the above-mentioned NPL 1).

The light source adopted for the above-described LiDAR uses, for example, a solid-state laser whose wavelength is strictly controlled and stabilized, and a receiving system uses a notch filter with an extremely narrow bandwidth that matches the wavelength of laser light. This results in significantly reducing false signals caused by sunlight or other external light. Light-receiving elements capable of achieving single-photon detection are used at low temperatures so as to minimize a generally-called dark count, that is, a frequency with which false signals occur. Although the point cloud data is acquired by a single shot, the accuracy of the point cloud data is increased by performing TOF measurements upon detection of two or more photons while suppressing the false signals in the above-described manner.

Meanwhile, the light source used in consumer LiDAR, which is expected to be used in the earlier-mentioned field of entertainment, is a small-size inexpensive semiconductor laser. It is known that the change occurring in the oscillation wavelength of a semiconductor laser ranges from several nanometers to ten-odd nanometers depending on injection current and temperature. The transmission wavelength width of the notch filter needs to be 10 nanometers or more. Therefore, the oscillation wavelength of the semiconductor laser is not sufficient to suppress the external light. Further, since the light-receiving elements are used in an environment with a temperature close to room temperature, the dark count cannot be ignored. In recent years, the use of the SPL method has been reported in conjunction with consumer LiDAR as well. However, in consideration of the above-mentioned false signals, the minimum number of detected photons is often larger than in the case of space-based LiDAR.

In view of the above problems, the present disclosure has been made to improve the maximum detectable distance, point cloud density, and distance accuracy of a distance sensor. Specifically, the present disclosure supports a single shot, provides single-photon detection, and thus makes it possible to minimize influence of false signals.

### <Embodiment>

### [Supplementary Technical Explanation]

Before describing the embodiment of the present disclosure, general statistical information is introduced below to facilitate the understanding of a technology according to the present disclosure. It is known that events of ten or fewer photons, such as the events to which the SPL method is applied, follow a Poisson distribution. In FIG. 1, the horizontal axis represents the expected value of the number of received photons, and the vertical axis represents a detection probability. Curves L1, L2, L3, and L4 depicted in FIG. 1 indicate cases where a detection threshold is one photon, two photons, three photons, and four photons, respectively. For example, in a case where the expected value of the number of photons is 4, the detection threshold is 98% for one photon, 91% for two photons, 76% for three photons, and 57% for four photons. In this case, where a relatively large number of photons are converted into electrons, there is no significant difference between the individual detection thresholds.

Meanwhile, when the expected value is 0.1, a great difference arises because the respective detection probability is 0.095, 0.0046, 0.0015, and 3.8 × 10⁻⁶. In a case where a three-dimensional shape is measured, validity exists even if the detection probability is less than 1. For example, in a case where 100 shots of laser light are emitted to a certain plane, the ability to obtain position information of two fixed points is overwhelmingly advantageous compared to a system that is unable to obtain such position information at all. If the cumulative number of measurement points is 1,000,000 per second, it indicates that nearly 20,000 effective points can be acquired in one second. When the expected value in the above-described example is 0.1 in a case where the detection threshold is one photon having a detection probability of 0.095 and in a case where the detection threshold is two photons having a detection probability of 0.0046, the cumulative detection probability over 40 shots is 0.98 and 0.17, respectively. Accordingly, in the latter case, 850 shots are required to achieve a detection probability of 0.98.

Time measurement and a time walk error will now be briefly explained to facilitate the understanding of the technology according to the present disclosure. In a case where TOF measurement is performed by a single shot, such as in the case of SPL, rise time detection of the output of the light-receiving element is made, and a TDC (time-to-digital converter) is often used as a time detector. The TDC for consumer LiDAR generally uses an inverter ring oscillator method, and the single-shot time resolution is approximately 20 to 300 ps. When a frequency of an inverter ring oscillator increases, the number of switching operations increases, resulting in an increase in power consumption. Meanwhile, the TDC used in space-based LiDAR is able to achieve a time resolution of approximately 1 ps. In a case where measurements are made with such a high time resolution, there arises a problem in which the time walk error occurs in a light-receiving element that is capable of detecting a single photon (one photon). This problem was fixed in the 1990s by SLR (Satellite Laser Ranging), and it is a phenomenon in which the measurement time shifts by a maximum of approximately 200 ps when the number of simultaneously arriving photons is 1 to 1000 (refer to the above-mentioned NPL 2). For example, a SPAD (single-photon avalanche diode) is a light-receiving element in which electron-hole pairs generated from one photon cause multiple collisions to obtain a gain of approximately 1 × 10⁶. However, the time required for electric charge saturation varies with the number of simultaneously received photons. For example, when one photon is received, the number of collisions is approximately 20. Meanwhile, when 1000 photons are received, the number of collisions is approximately 10. Therefore, the time required for detection becomes shorter when the number of simultaneously received photons increases. This is called the time walk error.

When multiple shots are accumulated to cause the horizontal axis to represent the time required for detection and cause the vertical axis to represent frequency, the distribution is discretized along the time axis. When groups of time required for detection are defined and designated as a one-photon group, a two-photon group, and so on in order from the shortest time to the longest time, a graph indicating the number of photons and delay time can be obtained. This graph can be used to correct the above-described time walk error. As a method for correcting time walk errors by a single shot, the number of photons is estimated from the time lag between two comparators having different thresholds, which were installed between a SPAD cathode and a quenching resistor and used in the same 1990s by SLR. Since a saturation charge amount does not change, the time required for avalanche multiplication is reflected in this case. When this method is adopted, a significant amount of time is required for re-discharging a gate. Therefore, in an environment where false signals occur, measurement becomes impossible due to the false signals. Consequently, using in a special environment, such as the environment where SLR is performed, is a prerequisite. Based on the above, the embodiment of the present disclosure will be described in detail.

### <Embodiment>

### [Example Configuration of Distance Measuring Device]

An example of the configuration of a distance measuring device (distance sensor) (hereinafter referred to as a distance measuring device 1000 as appropriate) according to the embodiment of the present disclosure will now be described with reference to FIG. 2. It should be noted that the distance measuring device 1000 does not need to include all of the component elements described below. Some of the component elements may be included in other devices. Further, a distance sensor system may be formed by such other devices and the distance measuring device 1000.

The distance measuring device 1000 includes, for example, a first aperture 101, a collecting mirror 102, and a second aperture 103 as the component elements of an optical system. Further, the distance measuring device 1000 includes, as circuits connected to the optical system, a light-receiving element 104, a replica 105, a balun transformer 106, which is an example of an extraction section, a first adjustment circuit 107, a second adjustment circuit 108, a resistor 130, a resistor 131, and a modulation circuit 132. The resistors 130 and 131 are connected at one end to the modulation circuit 132. The other end of the resistor 130 is the light-receiving element 104, the first adjustment circuit 107, and one primary terminal of the balun transformer 106. The other end of the resistor 131 is connected to the replica 105, the second adjustment circuit 108, and the other primary terminal of the balun transformer 106.

Further, the distance measuring device 1000 includes a differential amplifier 110, which is an example of an amplification section, a first comparator 111, a second comparator 112, a third comparator 113, a first buffer 114, a second buffer 115, a third buffer 116, a first TDC 121, a second TDC 122, a third TDC 123, a fourth TDC 124, a demultiplexer 125, and an FPGA (Field Programmable Gate Array) 126. These component elements are disposed on the secondary side of the balun transformer 106.

For example, one input terminal of the first comparator 111, one input terminal of the second comparator 112, and one input terminal of the third comparator 113 are connected to the output of the differential amplifier 110. A first threshold voltage 141 is inputted to the other input terminal of the first comparator 111. A second threshold voltage 142 is inputted to the other input terminal of the second comparator 112. A third threshold voltage 143 is inputted to the other input terminal of the third comparator 113. The first buffer 114 is connected to the output side of the first comparator 111. The second buffer 115 is connected to the output side of the second comparator 112. The third buffer 116 is connected to the output side of the third comparator 113. It should be noted that the first buffer 114, the second buffer 115, and the third buffer 116 need not necessarily be provided.

The output side of the first buffer 114 is connected to the first TDC 121, and the output of the first comparator 111 is supplied to the first TDC 121 through the first buffer 114. Further, a reference signal 151 is inputted to the first TDC 121. The output side of the second buffer 115 is connected to the second TDC 122, and the output of the second comparator 112 is supplied to the second TDC 122 through the second buffer 115. Furthermore, the reference signal 151 is inputted to the second TDC 122. The output side of the third buffer 116 is inputted to the demultiplexer 125. When the demultiplexer 125 operates, the output of the third comparator 113 is selectively inputted to the third TDC 123 and the fourth TDC 124 through the third buffer 116. Moreover, the reference signal 151 is inputted to the third TDC 123 and the fourth TDC 124.

Laser light emitted from a laser light source (not depicted) is reflected by a distance measurement target, and then the reflected light is inputted to the distance measuring device 1000. The reflected light is incident on the collecting mirror 102 through the first aperture 101. The first aperture 101 may be substituted by an alternative component element having the function of the first aperture 101. For example, a MEMS mirror, a galvanometer mirror, or other scanning elements may be used as the first aperture 101.

The collecting mirror 102 collects the reflected light. The collected reflected light passes through the second aperture 103. The second aperture 103 is a basic optical component for increasing a ratio of light reflected from the distance measurement target to external light, that is, improving the S/N (Signal Noise Ratio). The reflected light that has passed through the second aperture 103 is received by the light-receiving element 104.

The light-receiving element 104 is, for example, an element whose analog output value varies from a single-photon state to a multi-photon state. Although a SiPM (silicon photomultiplier) is used in the present embodiment, an alternative light-receiving element, such as an SNSPD (superconducting nanowire single-photon detector) array, may be used as the light-receiving element 104. The electrical equivalent circuit of the light-receiving element 104 can be represented, for example, as an RC circuit in which a resistor and a capacitor are connected in series. It should be noted that the equivalent circuit of the light-receiving element 104 may be divided into cells or synthesized down to the smallest element.

As the replica 105, an element similar to the light-receiving element 104, that is, an element that has the function of the light-receiving element 104 and is shielded from light, or an element replaced by an equivalent circuit is used. In the present embodiment, common mode noise introduced into signal lines is removed by connecting the light-receiving element 104 and its replica 105 to the primary side of the balun transformer 106.

Since the primary and secondary sides of the balun transformer 106 are insulated from each other, the base voltage on the primary side is the same as the voltage of a driving power source of light-receiving element 104, and the voltage of the secondary side, which is DC-connected to the differential amplifier 110, is equal to the offset voltage of the differential amplifier 110. High-frequency components of the light-receiving element 104 are extracted by the balun transformer 106 (transmitted to the secondary side).

The first adjustment circuit 107 and the second adjustment circuit 108 are circuits that adjust a time constant. A known circuit can be used as the circuit for adjusting the time constant. For example, the resistance and capacitance of the equivalent circuits of the light-receiving element 104 and replica 105 vary due, for instance, to manufacturing variations. Adjustment is made by the first adjustment circuit 107 and the second adjustment circuit 108 in order to eliminate such variations. The second adjustment circuit 108 may be integral with the replica 105.

The resistor 130 and the resistor 131 are, for example, resistors with substantially equal resistance values.

The modulation circuit 132 generates a predetermined modulation voltage. When the light-receiving element 104 and the replica 105 are connected to the modulation circuit 132 through the resistors 130 and 131, respectively, the modulation circuit 132 modulates the multiplication factor of the light-receiving element 104 at high speed and provides switching of avalanche amplification. This makes it possible to prevent false detection due to stray light noise or a dark count. A dip can be formed in a baseline of the signal lines by slightly changing the resistance values of the resistors 130 and 131 and the characteristics of the replica 105, making it possible to prevent false detection, for example, of common mode noise and stray light noise.

The differential amplifier 110 outputs a differential signal based on an input signal. A fully-differential amplifier may be used as the differential amplifier 110.

The first comparator 111, the second comparator 112, and the third comparator 113 output signals according to the result of comparison. The present embodiment is configured such that the distance measuring device 1000 includes three comparators. However, the distance measuring device 1000 needs to include at least three comparators with different threshold voltages. For example, the distance measuring device 1000 may include four or more comparators.

The first threshold voltage 141, the second threshold voltage 142, and the third threshold voltage 143 are different from each other. FIG. 3 is a diagram illustrating examples of the first threshold voltage 141, the second threshold voltage 142, and the third threshold voltage 143. In the present embodiment, the first threshold voltage 141 corresponds to a threshold voltage Vth3 for three-photon detection, the second threshold voltage 142 corresponds to a threshold voltage Vth2 for two-photon detection, and the third threshold voltage 143 corresponds to a threshold voltage Vth1 for one-photon detection. Here, the threshold voltage Vth1 is a threshold voltage corresponding to single-photon detection in at least a part of a measurement period. For example, the threshold voltage Vth3 for one-photon detection is set lower than the equivalent for one photon, and is often written as 0.5 p.e. (photo-electrons) (one photon is also referred to as one photoelectron). However, the threshold voltage Vth1 need not be strictly 0.5 and is acceptable as long as it is higher than a level of a baseline (or offset) noise. The threshold voltage Vth2 for two-photon detection is set higher than the equivalent for one photon and lower than the equivalent for two photons. Further, the threshold voltage Vth1 for three-photon detection is set higher than the equivalent for three photons and lower than the equivalent for three photons. When Vth1 ≤ Vth2 ≤ Vth3, the respective corresponding numbers of photons are not limited to the above and can be altered. When these voltages are controlled from the FPGA 126 or a writable memory, calibration and environmental adaptation can be facilitated.

As described above, the TDC is connected to each comparator. Each TDC determines the time lag according to the output of the comparator and to the reference signal. Each TDC corresponds to an example of a time lag measuring section. For example, upon receiving a signal (e.g., a high-level signal) indicating that the output voltage of the differential amplifier 110 is higher than the first threshold voltage 141, the first TDC 121 determines dT3, which is the time lag between the reception of the signal and the input of the reference signal 151 (see FIG. 3). Upon receiving a signal (e.g., a high-level signal) indicating that the output voltage of the differential amplifier 110 is higher than the second threshold voltage 142, the second TDC 122 determines dT2, which is the time lag between the reception of the signal and the input of the reference signal 151 (see FIG. 3). Upon receiving a signal (e.g., a high-level signal) indicating that the output voltage of the differential amplifier 110 is higher than the third threshold voltage 143, the third TDC 123 determines dT1, which is the time lag between the reception of the signal and the input of the reference signal 151 (see FIG. 3). Upon receiving a signal (e.g., a high-level signal) indicating that the output voltage of the differential amplifier 110 is higher than the third threshold voltage 143, the fourth TDC 124 determines dT1, which is the time lag between the reception of the signal and the input of the reference signal 151 (see FIG. 3).

The third TDC 123 and the fourth TDC 124 are connected to the demultiplexer 125. The demultiplexer 125 switches the supply destination of the output of the third comparator 113 to the third TDC 123 or to the fourth TDC 124. More specifically, the demultiplexer 125 exercises control such that the first output of the third comparator 113 in a measurement period (e.g., the period between the emission of laser light and the reception of light reflected from the distance measurement target) is supplied to the third time lag measuring section 123, and that the second output of the third comparator 113, which is outputted after the first output in the above-mentioned measurement period, is supplied to the fourth time lag measuring section 124.

The FPGA 126 is a programmable integrated circuit. Time lag data indicating the time lag determined by each TDC is inputted to the FPGA 126. The FPGA 126 performs processes such as time lag data noise removal and error correction, time lag data conversion to distance data and to point cloud data, and point cloud reconstruction. Specifically, the FPGA 126 performs the processes so as to determine the number of photons corresponding to the time lag and the time walk error corresponding to the number of photons, correct a provisional time lag based on the time lag by using the time walk error, and calculate a distance to the target according to a result of correction.

Further, it is obvious that, for example, a control section for overall control of a distance measuring device, a light source, a scanning section, and appropriate optical components can be added as needed to the distance measuring device 1000.

### [Example Operation of Distance Measuring Device]

An example of the operation of the distance measuring device 1000 will now be described. A part of pulsed laser light outputted from the light source (not depicted) is converted into an electrical signal by the light-receiving element (not depicted), and is inputted to each TDC through a comparator or the like as the reference signal 151. Meanwhile, the pulsed laser light passes through a scanning section (not depicted), such as a MEMS mirror, and falls on the distance measurement target.

The reception angle of the light reflected from the distance measurement target is limited by the first aperture 101. Therefore, the larger the first aperture 101, the more light can be received. For example, when a MEMS mirror is used as the first aperture 101, the light can be received by an area of approximately several tens of square millimeters. External light, such as sunlight, can be reduced by the collecting mirror 102 and the second aperture 103. The external light may be further reduced by disposing and using the above-mentioned optical system components together with a notch filter that does not transmit light other than the wavelength of the laser light. The reflected light is received by the light-receiving element 104.

In the present embodiment, a SiPM is used as the light-receiving element 104. The SiPM is a light-receiving element having multiple SPADs connected in parallel, and the common mode noise is likely to be mixed into the output of the SiPM due to a capacitor formed by a PN junction and a parasitic capacitor of the quenching resistor. As described earlier, a balance circuit formed by the replica 105 and the balun transformer 106 cancels the common mode noise and does not transmit the common mode noise to the secondary side of the balun transformer 106. In a state of balance, the transmission of the modulation voltage to the secondary side of the balun transformer 106 is suppressed even if the driving voltage for the SiPM is modulated by the modulation circuit 132. Further, when the first and second adjustment circuits 107 and 108 are appropriately adjusted, the secondary side of the balun transformer 106 is slightly modulated in synchronism with the modulation circuit 132.

When there are few incoming photons, an electric charge generated in the light-receiving element 104 that has received the light, that is, the electric charge generated in a SiPM cell, charges a cell that has not received the light, and then passes through the primary side of the balun transformer 106 to charge the replica. When the imbalance between the SiPM and the replica 105 is resolved, the electric charge applied to the power supply or the modulation circuit 132 is decreased (reduced to the original electric charge level). A detection frequency propagating to the secondary side can be adjusted in the range of several hundred piroseconds to several ns by adjusting the inductance of the balun transformer 106 and the rate of coupling to the secondary side. That is, only the high-frequency components of the rising output of the SiPM are extracted by the balun transformer 106, and the extracted high-frequency components are amplified by the differential amplifier 110 in the output stage. Since a small number of photons received by the SiPM, which follow the Poisson distribution, generate 1 × 10⁶ electrons by avalanche multiplication, it is conceivable that a normal distribution will be followed after the output of the SiPM. Therefore, when the rising output of the differential amplifier 110 is detected by at least three comparators, a jitter generated subsequently to the comparators can be averaged out.

When the time lag between the reference signal 151 and the output of each comparator (first comparator 111, second comparator 112, and third comparator 113) is measured by the respective TDC, the time lags dT1, dT2, and dT3, which are depicted in FIG. 2, are obtained. The obtained time lags are supplied to the FPGA 126.

The expected values of these time lags gradually increase. Therefore, the number of photons received by the SiPM can be estimated by comparing dT1, dT2, and dT3. Since these values are non-linear and are further affected by variations of the respective elements, the FPGA 126 performs a conversion by using, for example, a LUT (lookup table). The contents of the LUT may be determined by calibration or based on an analytical solution. It should be noted that, as long as the number of photons is estimated from dT1, dT2, and dT3, the LUT need not necessarily be used to estimate the number of photons.

The FPGA 126 determines the provisional time lag based on the time lags dT1, dT2, and dT3. The method of calculating the provisional time lags is not specifically limited to any kind. For example, the average value of three time lags may be used, or the value of a time lag dT1 may be used. Then, the time walk error corresponding to the estimated number of photons is determined by referencing, for example, the LUT, and the provisional time lag is corrected so as to cancel the time walk error. Subsequently, the FPGA 126 calculates the distance to the distance measurement target by multiplying the corrected time lag by the speed of light and halving the resulting value. The calculated distance is used in a manner appropriate for the purpose of an application.

As mentioned above, the time resolution of a TDC using an inverter ring oscillator used in consumer LiDAR is low. Therefore, time walk errors are buried in a single-shot noise of the TDC. In the embodiment of the present disclosure, a fine TDC having a time resolution on the order of ps is used, and for example, PSGBR (pulse shrink gated buffering) or VGBR (vernier gated buffering) is incorporated. The above-mentioned fine TDC has such characteristics that it is not significantly affected by high cost due to semiconductor miniaturization possibly required for existing inverter ring oscillator or by increased power consumption due to operating frequency improvement, or the like.

It should be noted that the above description describes an example of the operation performed in a case where three or more photons are received by the light-receiving element 104. In the case where three or more photons are received, the number of photons can be estimated according to the difference in dT3. Further, in a case where two photons are received by the light-receiving element 104, the first comparator 111 outputs a signal (for example, a low-level signal) indicating that the voltage is lower than the first threshold voltage 141. In this case, the provisional time lag is determined based on dT2 and dT3. In a case where one photon is received by the light-receiving element 104, the provisional time lag is determined based on dT1.

### [Single-Photon Detection]

The following description indicates that the distance measuring device 1000 according to the present embodiment is capable of achieving single-photon detection and making distance measurement based on single-photon detection.

FIG. 4 is a diagram relating to the configuration of the distance measuring device 1000 according to the embodiment of the present disclosure and illustrating a relation between exposure time (horizontal axis) and the expected value (vertical axis) of the number of photons received by the light-receiving element 104 (the SiPM in the present embodiment) in a case where the illuminance of external light is 10,000 lux. When the exposure time (approximately the reciprocal of the detection frequency of the balun transformer 106) is 1 ns, the expected value of the number of photons is 0.0425. Therefore, in a 10,000-lux environment, a false signal equivalent to one photon occurs due to external light several times in a period during which one cycle of measurement can be made, that is, in a period during which a measurement system can accept a signal after the emission of pulsed laser light. Further, in an environment where the illuminance of external light is 1,000 lux, the expected value of the number of photons received is one order of magnitude lower, namely, 0.00425. A false signal equivalent to one photon due to external light occurs approximately once every several cycles.

If a cutoff frequency of the secondary side of the balun transformer 106 is approximately 1 GHz, the probability of receiving two photons simultaneously in a 10,000-lux environment is lower than 0.001, and a false signal occurs due to one photon. Since the expected value of the number of photons for external light varies depending on a system configuration, the cutoff frequency is adjusted by changing the configuration of the balun transformer 106 as appropriate. It should be noted that the pulse width of the pulsed laser light is several tens of picoseconds. Therefore, the light reflected from an object can be considered as being received simultaneously by the SiPM.

The dark count of SiPM is approximately 1 MHz at 30°C, which signifies that a false signal occurs due to the dark count once every several cycles. As described above, the false signal is suppressed to a one-photon level. Therefore, it is possible to avoid a false signal propagation from the comparator to the TDC by setting a detection threshold voltage of the comparator to 1.5 photons (the amount of charge generated in a case where 1.5 photons are received). However, the light reflected from an object is very weak. Therefore, measurements cannot be made in a case where one photon is received by the SiPM.

Therefore, single-photon detection is made possible by setting the third threshold voltage 143 to be equivalent to, for example, 0.5 photons. Further, in a case, for example, where the SiPM operates at room temperature in a 1,000-lux environment, the third TDC 123 that supports one-photon detection operates approximately once every several cycles due to a false signal. Therefore, in a case where the third TDC 123 receives a high-level signal (a signal indicating that the input is higher than the third threshold voltage 143) from the third comparator 113 as depicted in FIG. 5, the result of such signal reception is fed back to the demultiplexer 125 in the input stage. For example, a feedback signal 127 is given to the demultiplexer 125. Upon receiving the feedback signal 127, the demultiplexer 125 switches the connection destination of the third comparator 113 from the third TDC 123 to the fourth TDC 124. As a result, even in a case where the third TDC 123 operates due to a false signal (a signal SA in FIG. 5), a true signal (a signal SB in FIG. 5) can be detected by the fourth TDC 124.

It should be noted that the distance measuring device 1000 may include an illuminance sensor that detects a level of external light. Then, in a case where such an illuminance sensor is provided, the illuminance of external light is low, and the occurrence of false signals is small, the demultiplexer 125 may be made inoperative.

It should be noted that the expected value of the number of photons received by the light-receiving element 104 also varies with the distance to the distance measurement target. FIG. 6 is a diagram relating to the distance measuring device according to the present embodiment and illustrating a relation between the distance and the expected value of the number of photons received according to the distance. Here, it is assumed that the reflectance of the distance measurement target is 30%. When the distance to the distance measurement target is 10 m or more, the expected value of the number of received photons decreases monotonically. Further, when the distance to the distance measurement target is less than 10 m, the expected value of the number of photons decreases due to the characteristics of the collecting mirror 102. In entertainment applications, the distance to the distance measurement target is often 1 to 20 m. Meanwhile, when, for example, real-time point cloud data on sports events held in stadiums or high-definition point cloud data on buildings and other structures is to be acquired, a measurable distance of up to 50 m is demanded. When the distance to the distance measurement target is less than 20 m, the expected value of the number of photons is 3 or more, and there is a high probability that two or more photons can be detected at the same time. Therefore, the accuracy of point cloud data increases when the detection threshold voltage of a comparator that is less likely to detect false signals is set to 1.5 photoelectrons or more. Meanwhile, when the distance to the distance measurement target is 20 m or more, the expected value of the number of photons is 3 or less, and the probability of detecting two or more photons at the same time becomes low. Consequently, it is necessary to additionally make use of one-photon detection.

The demultiplexer 125 sets the output destination of the third comparator 113 to the third TDC 123 between a reference timing Ref (e.g., beginning of measurement) and a timing at which light reflected from the distance measurement target located at a distance of 20 m is received. After the timing at which the light reflected from the distance measurement target located at a distance of 20 m is received, that is, when a frequency of one-photon detection increases, the demultiplexer 125 sets the output destination of the third comparator 113 to the fourth TDC 124. This makes it possible to prevent the fourth TDC 124 from malfunctioning due to a false signal generated before the above-mentioned timing.

It should be noted that the distance measuring device 1000 may exclude the demultiplexer 125 and the fourth TDC 124 and include a switch 128 as depicted in FIG. 7. The switch 128 is disposed in the input stage of the third TDC 123 and connected to the third comparator 113. For example, as depicted in FIG. 8, when the switch 128 is turned off (closed) between the Ref and a timing at which light reflected from an object located at a distance of 20 m or more is detected, and then turned on (opened) at the timing at which the light reflected from the object located at a distance of 20 m or more is detected, it is possible to prevent the third TDC 123 from malfunctioning due to a false signal generated before the above-mentioned timing.

It should be noted that, similarly, the switch may be disposed in the input stage of the first TDC 121 and the second TDC 122 to open the first TDC 121 and the second TDC 122 only at a desired timing. Further, the switch need not necessarily be separate from the TDCs, and the functionality of the switch may be incorporated into the TDCs or incorporated into the demultiplexer 125 and the buffers. For example, the FPGA 126 may be configured to be able to change an on/off state of the switch such that the period during which the switch is on (open) can be changed in response to a change, for example, in external light intensity.

Further, the threshold voltage of the comparator may be changed. For example, in a case where a frequency of two-photon detection is high (see FIG. 6) when the distance to the distance measurement target is less than 20 m, the third TDC 123 may be assigned for two-photon detection. For example, as depicted in FIG. 9, the third threshold voltage 143 (threshold voltage Vth1) of the third comparator 113 is modulated to make the threshold voltage at a distance of less than 20 m from the reference timing Ref higher than the threshold voltage. As a result, the threshold voltage is set to a threshold voltage that does not allow single-photon detection. The threshold voltage at a distance of 20 m or more from the reference timing Ref is modulated so as to correspond to one-photon detection. This enables the third TDC 123 to detect two or more photons at a distance of less than 20 m, and detect one or more photons at a distance of 20 m or more. The threshold voltage may be discrete or continuous. Further, the threshold voltage of not only the third comparator 113 but also the other comparators may be modulated.

As depicted in FIG. 10, the offset (baseline) may be modulated. The driving voltage for the light-receiving element 104 SiPM can be modulated by a predetermined modulation circuit (not depicted) to allow the offset to be modulated by a slight mismatch in a circuit on the primary side of the balun transformer 106. When modulated, the offset increases, then provides Vth1, which allows one-photo detection at a timing after a lapse of a predetermined period, and makes it possible to achieve one-photon detection. Photon detection can be prevented from occurring before the above-mentioned timing. Since the offset is formed at a stage where it is inputted to the differential amplifier 110, the offset is able to similarly affect the first comparator 111, the second comparator 112, and the third comparator 113. It should be noted that, although the threshold voltage and the offset change continuously in FIGS. 9 and 10, they may change stepwise. Further, the above-mentioned distance threshold (e.g., 20 m) can be changed as appropriate according to the application targeted by the distance measuring device 1000.

As described above, the distance measuring device according to the present embodiment is able to achieve accurate one-photon detection. That is, since distance measurement corresponding to one-photon detection can be made, the range of measurable distance can also be extended. Further, the density of point cloud and the accuracy of distance measurement can be improved. Furthermore, the distance measuring device according to the present embodiment supports a single shot, provides one-photon detection, and thus makes it possible to minimize influence of false signals.

### <Modifications>

While the embodiment of the present disclosure has been specifically described above, the contents of the present disclosure are not limited to the above-described embodiment, and various modifications can be made based on the technical idea of the present disclosure.

The time lag dT1 occurs when the number of simultaneously received photons is larger than that in the case of the time lags dT2 and dT3. Therefore, the influence of false signals is the smallest in the case of the time lag dT1, and a level of reliability, which is the accuracy of a signal, is dT1 > dT2 > dT. It signifies that the larger the minimum number of measurable photons, the higher the level of reliability. Therefore, when the provisional time lag is to be determined or the time walk error is to be corrected, the weight of the time lag dT1 may be increased. When a value corresponding to the weight (a digital value indicating the level of reliability) is added to point cloud data, for example, as a header, back-end software processing can be performed also based on highly accurate point cloud data in a manner appropriate for various applications. As a result, for example, accuracy improvement and processing time reduction can be expected. The format of the value corresponding to the above-mentioned weight is not limited to any kind, so that such a value can be added to an appropriate position other than the header of the point cloud data.

In the embodiment described above, the number of TDC stages connected to the demultiplexer is not limited to two and can be increased as appropriate. The number of TDC stages connected to the demultiplexer is appropriately determined in consideration of the use and cost of consumer LiDAR.

The present disclosure can be implemented not only by a distance measuring device but also by a vehicle-mounted device having the distance measuring device or by using an appropriate form such as a method. It should be noted that advantages described in this document are merely illustrative and not restrictive. The present disclosure can additionally provide advantages other than those described in this document.

It should be noted that the present disclosure may adopt the following configurations as well.
(1) A distance measuring device including:
   a light-receiving element that is able to achieve single-photon detection and that generates an analog output that varies with the number of simultaneously received photons;
   an extraction section that extracts high-frequency components of an output of the light-receiving element;
   an amplification section that amplifies an output of the extraction section; and
   at least three comparators that receive supply of an output from the amplification section and have different threshold voltages,
   in which the threshold voltage set for a predetermined one of the comparators is a threshold voltage corresponding to single-photon detection in at least a part of a measurement period.
(2) The distance measuring device according to (1), further including:
   a time lag measuring section that is connected to a respective one of the comparators in order to determine a time lag according to an output of the respective comparator and to a reference signal; and
   a distance calculation section that determines the number of photons corresponding to the time lag and a time walk error corresponding to the number of photons, corrects a provisional time lag based on the time lag by using the time walk error, and calculates a distance to a target according to a result of correction.
(3) The distance measuring device according to (2), further including:
   a demultiplexer connected to a comparator that is set to the threshold voltage corresponding to the single-photon detection; and
   at least a first time lag measuring section and a second time lag measuring section that are connected to the demultiplexer.
(4) The distance measuring device according to (3),
   in which the demultiplexer exercises control to supply a first output of the comparator in a measurement period to the first time lag measuring section, and supply a second output of the comparator to the second time lag measuring section, the second output being generated after the first output in the measurement period.
(5) The distance measuring device according to (2),
   in which a switch is connected between the comparator set to the threshold voltage corresponding to the single-photon detection and the time lag measuring section connected to the comparator, and is controlled during a predetermined period to turn on from an off state.
(6) The distance measuring device according to (5),
   in which the period during which the switch is on is changed according to intensity of external light.
(7) The distance measuring device according to (2),
   in which the threshold voltage corresponding to the single-photon detection is set to a first threshold voltage at beginning of the measurement period and then switched to a second threshold voltage after a lapse of a predetermined time from the beginning of the measurement period, the single-photon detection being unachievable at the first threshold voltage and achievable at the second threshold voltage.
(8) The distance measuring device according to (7),
   in which the threshold voltage corresponding to the single-photon detection continuously changes from the first threshold voltage to the second threshold voltage.
(9) The distance measuring device according to (2),
   in which the single-photon detection becomes achievable at a predetermined timing when a baseline for the output of the extraction section rises from beginning of measurement.
(10) The distance measuring device according to any one of (2) to (9),
   in which a level of reliability is set for the time lag determined by each time lag measuring section, and at least either one of the time walk error and the provisional time lag is determined by using a weight on a basis of the level of reliability, and
   the larger the minimum number of measurable photons, the higher the setting of the level of reliability.
(11) The distance measuring device according to any one of (1) to (10),
   in which the extraction section includes a balun transformer.
(12) A vehicle-mounted device including:
   a distance measuring device according to any one of (1) to (11).

### <Examples of Application>

Examples of application of the present disclosure will now be described. It should be noted, however, that the present disclosure is not limited to the following examples of application.

### [First Example of Application]

The use of real-time point cloud data in sports application is extended, for example, to training, injury prevention, and broadcasting. A coaxial optical system that has the light source including a Q-switching pulsed semiconductor laser, has the scanning section including a MEMS mirror, irradiates an object with pulsed laser light, and uses the MEMS mirror to receive light reflected from the object is described below as an example of a distance sensor including the receiving section to measuring sections in the distance measuring device described in conjunction with the embodiment of the present disclosure. The amplitude of the MEMS mirror in the scanning section can be controlled by driving voltage and frequency, and the FOV (viewing angle) may be widened or narrowed depending on the measurement target while complying with laser safety class 1. In a case where the maximum measurement distance is 20 m, it is assumed that the point cloud density is 5 million points/second, and that the FOV is approximately 60 degrees, and further that the distance accuracy of a single shot is approximately 1 mm at a position of several meters. FIG. 11 depicts one-shot point cloud data measured at a high frame rate, which captures the details of body movement (a golf swing in the example of FIG. 11).

In order to more accurately capture the body movement, it is desirable to acquire point cloud data in at least three directions. Further, high-definition point cloud data can be acquired by acquiring the point cloud data in the same direction through the use of multiple distance sensors and superimposing multiple sets of the acquired point cloud data. The probability of single-shot, scanning distance sensors interfering with each other is extremely low, and it is possible to acquire point cloud data proportional to the number of simultaneously used distance sensors. However, the laser usage efficiency of existing consumer LiDARis low, so that accumulation is difficult to achieve because of heat generated by power consumption. Meanwhile, the above-mentioned problems can be overcome by using the method described in conjunction with the embodiment of the present disclosure, which supports a single shot and provides single-photon detection.

For judgment and broadcast of sports, for example, it is also possible to tile approximately 20 units and acquire point cloud data at a rate of up to 100 million points/second by using such multiple units. In a case where reconstruction is performed from such a huge amount of point cloud data, point cloud accuracy parameters described in conjunction with the embodiment of the present disclosure can be effectively used to improve real-time performance and reduce costs associated with processing time.

### [Second Example of Application]

In recent years, the use of a digital space, such as a metaverse, has progressed. Distance sensors are utilized as a method of connecting a real space to a digital space. In a case where individuals to small groups are targeted, high-definition point cloud data and real-time performance are required. Although there are many methods of utilizing high-definition distance sensors at short distances of several meters, sufficient accuracy has not been obtained in a case where movement, such as dancing, is involved. These problems can be overcome by using one or more distance sensors described above. In a real space with a large number of people, it is difficult to build distance data by using a stereo-camera method due to occlusion. Further, in a case where the existing LiDAR method is used, it is difficult to identify the target from a measured point due to low point cloud density. When, for example, approximately 20 distance sensors mentioned above are tiled to use multiple units capable of acquiring point cloud data at a rate of up to 100 million points/second, it is possible to obtain point cloud data of a person behind other persons from the gaps between the other persons. In a case where reconstruction is performed from such a huge amount of point cloud data, the point cloud accuracy parameters described in conjunction with the embodiment of the present disclosure can be effectively used to improve real-time performance and reduce costs associated with processing time.

### [Third Example of Application]

In recent years, movie shooting techniques using virtual production have been developed. A real space is acquired as point cloud data, reconstructed, and converted into computer graphics or displayed on a large display, and reshot. The cost of acquiring a large amount of point cloud data is enormous,d so that the use of inexpensive equipment and the reduction of acquisition time are demanded. Consumer LiDAR, which is described in conjunction with the embodiment of the present disclosure, is inexpensive and is capable of achieving a high point cloud density and, in addition, performing tiling as described earlier. When, for example, approximately 20 units are tiled to use multiple units capable of acquiring point cloud data at a rate of up to 100 million points/second, it is expected that the time required for point cloud acquisition will be significantly reduced to achieve cost reduction. In a case where such a huge amount of point cloud data is used to perform reconstruction, effective use of the point cloud accuracy parameters described in conjunction with the embodiment of the present disclosure will result in improving real-time performance and reducing the costs associated with processing time.

### [Fourth Example of Application]

Real-time, high-precision distance sensors can be used to automate camera work during the use of movie shooting techniques. In the case of shooting videos from an artistic perspective, it is essential to be skilled not only in focusing on the target but also in producing effects appropriate for the space to be expressed. Automation from the artistic perspective can be achieved through deep learning that is performed by comparing the point cloud data acquired in real time with actual effects. Consumer LiDAR, which is described in conjunction with the embodiment of the present disclosure, inexpensive and is capable of achieving a high point cloud density and, in addition, performing tiling as described earlier. When, for example, approximately 20 units are tiled to use multiple units capable of acquiring the point cloud data at a rate of up to 100 million points/second, it is expected that the time required for point cloud acquisition will significantly decrease to achieve cost reduction. In the case where such a huge amount of point cloud data is used to perform reconstruction, the effective use of the point cloud accuracy parameters described in conjunction with the embodiment of the present disclosure will result in improving real-time performance and reducing the costs associated with processing time.

### [Other Examples of Application]

The technology according to the present disclosure can be applied to various products. For example, the technology according to the present disclosure may be implemented as a device that is to be mounted in any one of various types of mobile bodies, such as automobiles, electric vehicles, hybrid electric vehicles, motorcycles, bicycles, personal mobility devices, airplanes, drones, ships, robots, construction machines, and agricultural machines (tractors).

FIG. 12 is a block diagram depicting an example of schematic configuration of a vehicle control system 7000 as an example of a mobile body control system to which the technology according to the embodiment of the present disclosure can be applied. The vehicle control system 7000 includes multiple electronic control units connected to each other via a communication network 7010. In the example depicted in FIG. 12, the vehicle control system 7000 includes a driving system control unit 7100, a body system control unit 7200, a battery control unit 7300, an outside-vehicle information detecting unit 7400, an in-vehicle information detecting unit 7500, and an integrated control unit 7600. The communication network 7010 connecting the multiple control units to each other may, for example, be a vehicle-mounted communication network compliant with an arbitrary standard such as controller area network (CAN), local interconnect network (LIN), local area network (LAN), FlexRay (registered trademark), or the like.

Each of the control units includes: a microcomputer that performs arithmetic processing according to various kinds of programs; a storage section that stores the programs executed by the microcomputer, parameters used for various kinds of operations, or the like; and a driving circuit that drives various kinds of control target devices. Each of the control units further includes: a network interface (I/F) for performing communication with other control units via the communication network 7010; and a communication I/F for performing communication with a device, a sensor, or the like within and without the vehicle by wire communication or radio communication. A functional configuration of the integrated control unit 7600 illustrated in FIG. 12 includes a microcomputer 7610, a general-purpose communication I/F 7620, a dedicated communication I/F 7630, a positioning section 7640, a beacon receiving section 7650, an in-vehicle device I/F 7660, a sound/image output section 7670, a vehicle-mounted network I/F 7680, and a storage section 7690. The other control units similarly include a microcomputer, a communication I/F, a storage section, and the like.

The driving system control unit 7100 controls the operation of devices related to the driving system of the vehicle in accordance with various kinds of programs. For example, the driving system control unit 7100 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like. The driving system control unit 7100 may have a function as a control device of an antilock brake system (ABS), electronic stability control (ESC), or the like.

The driving system control unit 7100 is connected with a vehicle state detecting section 7110. The vehicle state detecting section 7110, for example, includes at least one of a gyro sensor that detects the angular velocity of axial rotational movement of a vehicle body, an acceleration sensor that detects the acceleration of the vehicle, and sensors for detecting an amount of operation of an accelerator pedal, an amount of operation of a brake pedal, the steering angle of a steering wheel, an engine speed or the rotational speed of wheels, and the like. The driving system control unit 7100 performs arithmetic processing using a signal input from the vehicle state detecting section 7110, and controls the internal combustion engine, the driving motor, an electric power steering device, the brake device, and the like.

The body system control unit 7200 controls the operation of various kinds of devices provided to the vehicle body in accordance with various kinds of programs. For example, the body system control unit 7200 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source for the driving motor, in accordance with various kinds of programs. For example, the battery control unit 7300 is supplied with information about a battery temperature, a battery output voltage, an amount of charge remaining in the battery, or the like from a battery device including the secondary battery 7310. The battery control unit 7300 performs arithmetic processing using these signals, and performs control for regulating the temperature of the secondary battery 7310 or controls a cooling device provided to the battery device or the like.

The outside-vehicle information detecting unit 7400 detects information about the outside of the vehicle including the vehicle control system 7000. For example, the outside-vehicle information detecting unit 7400 is connected with at least one of an imaging section 7410 and an outside-vehicle information detecting section 7420. The imaging section 7410 includes at least one of a time-of-flight (ToF) camera, a stereo camera, a monocular camera, an infrared camera, and other cameras. The outside-vehicle information detecting section 7420, for example, includes at least one of an environmental sensor for detecting current atmospheric conditions or weather conditions and a peripheral information detecting sensor for detecting another vehicle, an obstacle, a pedestrian, or the like on the periphery of the vehicle including the vehicle control system 7000.

The environmental sensor, for example, may be at least one of a rain drop sensor detecting rain, a fog sensor detecting a fog, a sunshine sensor detecting a degree of sunshine, and a snow sensor detecting a snowfall. The peripheral information detecting sensor may be at least one of an ultrasonic sensor, a radar device, and a LIDAR device (Light detection and Ranging device, or Laser imaging detection and ranging device). Each of the imaging section 7410 and the outside-vehicle information detecting section 7420 may be provided as an independent sensor or device, or may be provided as a device in which multiple sensors or devices are integrated.

FIG. 13 depicts an example of installation positions of the imaging section 7410 and the outside-vehicle information detecting section 7420. Imaging sections 7910, 7912, 7914, 7916, and 7918 are, for example, disposed at at least one of positions on a front nose, sideview mirrors, a rear bumper, and a back door of the vehicle 7900 and a position on an upper portion of a windshield within the interior of the vehicle. The imaging section 7910 provided to the front nose and the imaging section 7918 provided to the upper portion of the windshield within the interior of the vehicle obtain mainly an image of the front of the vehicle 7900. The imaging sections 7912 and 7914 provided to the sideview mirrors obtain mainly an image of the sides of the vehicle 7900. The imaging section 7916 provided to the rear bumper or the back door obtains mainly an image of the rear of the vehicle 7900. The imaging section 7918 provided to the upper portion of the windshield within the interior of the vehicle is used mainly to detect a preceding vehicle, a pedestrian, an obstacle, a signal, a traffic sign, a lane, or the like.

Incidentally, FIG. 13 depicts an example of photographing ranges of the respective imaging sections 7910, 7912, 7914, and 7916. An imaging range a represents the imaging range of the imaging section 7910 provided to the front nose. Imaging ranges b and c respectively represent the imaging ranges of the imaging sections 7912 and 7914 provided to the sideview mirrors. An imaging range d represents the imaging range of the imaging section 7916 provided to the rear bumper or the back door. A bird's-eye image of the vehicle 7900 as viewed from above can be obtained by superimposing image data imaged by the imaging sections 7910, 7912, 7914, and 7916, for example.

Outside-vehicle information detecting sections 7920, 7922, 7924, 7926, 7928, and 7930 provided to the front, rear, sides, and corners of the vehicle 7900 and the upper portion of the windshield within the interior of the vehicle may be, for example, an ultrasonic sensor or a radar device. The outside-vehicle information detecting sections 7920, 7926, and 7930 provided to the front nose of the vehicle 7900, the rear bumper, the back door of the vehicle 7900, and the upper portion of the windshield within the interior of the vehicle may be a LIDAR device, for example. These outside-vehicle information detecting sections 7920 to 7930 are used mainly to detect a preceding vehicle, a pedestrian, an obstacle, or the like.

Returning to FIG. 12, the description will be continued. The outside-vehicle information detecting unit 7400 makes the imaging section 7410 image an image of the outside of the vehicle, and receives imaged image data. In addition, the outside-vehicle information detecting unit 7400 receives detection information from the outside-vehicle information detecting section 7420 connected to the outside-vehicle information detecting unit 7400. In a case where the outside-vehicle information detecting section 7420 is an ultrasonic sensor, a radar device, or a LIDAR device, the outside-vehicle information detecting unit 7400 transmits an ultrasonic wave, an electromagnetic wave, or the like, and receives information of a received reflected wave. On the basis of the received information, the outside-vehicle information detecting unit 7400 may perform processing of detecting an object such as a human, a vehicle, an obstacle, a sign, a character on a road surface, or the like, or processing of detecting a distance thereto. The outside-vehicle information detecting unit 7400 may perform environment recognition processing of recognizing a rainfall, a fog, road surface conditions, or the like on the basis of the received information. The outside-vehicle information detecting unit 7400 may calculate a distance to an object outside the vehicle on the basis of the received information.

In addition, on the basis of the received image data, the outside-vehicle information detecting unit 7400 may perform image recognition processing of recognizing a human, a vehicle, an obstacle, a sign, a character on a road surface, or the like, or processing of detecting a distance thereto. The outside-vehicle information detecting unit 7400 may subject the received image data to processing such as distortion correction, alignment, or the like, and combine the image data imaged by multiple different imaging sections 7410 to generate a bird's-eye image or a panoramic image. The outside-vehicle information detecting unit 7400 may perform viewpoint conversion processing using the image data imaged by the imaging section 7410 including the different imaging parts.

The in-vehicle information detecting unit 7500 detects information about the inside of the vehicle. The in-vehicle information detecting unit 7500 is, for example, connected with a driver state detecting section 7510 that detects the state of a driver. The driver state detecting section 7510 may include a camera that images the driver, a biosensor that detects biological information of the driver, a microphone that collects sound within the interior of the vehicle, or the like. The biosensor is, for example, disposed in a seat surface, the steering wheel, or the like, and detects biological information of an occupant sitting in a seat or the driver holding the steering wheel. On the basis of detection information input from the driver state detecting section 7510, the in-vehicle information detecting unit 7500 may calculate a degree of fatigue of the driver or a degree of concentration of the driver, or may determine whether the driver is dozing. The in-vehicle information detecting unit 7500 may subject an audio signal obtained by the collection of the sound to processing such as noise canceling processing or the like.

The integrated control unit 7600 controls general operation within the vehicle control system 7000 in accordance with various kinds of programs. The integrated control unit 7600 is connected with an input section 7800. The input section 7800 is implemented by a device capable of input operation by an occupant, such, for example, as a touch panel, a button, a microphone, a switch, a lever, or the like. The integrated control unit 7600 may be supplied with data obtained by voice recognition of voice input through the microphone. The input section 7800 may, for example, be a remote control device using infrared rays or other radio waves, or an external connecting device such as a mobile telephone, a personal digital assistant (PDA), or the like that supports operation of the vehicle control system 7000. The input section 7800 may be, for example, a camera. In that case, an occupant can input information by gesture. Alternatively, data may be input which is obtained by detecting the movement of a wearable device that an occupant wears. Further, the input section 7800 may, for example, include an input control circuit or the like that generates an input signal on the basis of information input by an occupant or the like using the above-described input section 7800, and which outputs the generated input signal to the integrated control unit 7600. An occupant or the like inputs various kinds of data or gives an instruction for processing operation to the vehicle control system 7000 by operating the input section 7800.

The storage section 7690 may include a read only memory (ROM) that stores various kinds of programs executed by the microcomputer and a random access memory (RAM) that stores various kinds of parameters, operation results, sensor values, or the like. In addition, the storage section 7690 may be implemented by a magnetic storage device such as a hard disc drive (HDD) or the like, a semiconductor storage device, an optical storage device, a magnetooptical storage device, or the like.

The general-purpose communication I/F 7620 is a communication I/F used widely, which communication I/F mediates communication with various apparatuses present in an external environment 7750. The general-purpose communication I/F 7620 may implement a cellular communication protocol such as global system for mobile communications (GSM (registered trademark)), worldwide interoperability for microwave access (WiMAX (registered trademark)), long term evolution (LTE (registered trademark)), LTE-advanced (LTE-A), or the like, or another wireless communication protocol such as wireless LAN (referred to also as wireless fidelity (Wi-Fi (registered trademark)), Bluetooth (registered trademark), or the like. The general-purpose communication I/F 7620 may, for example, connect to an apparatus (for example, an application server or a control server) present on an external network (for example, the Internet, a cloud network, or a company-specific network) via a base station or an access point. In addition, the general-purpose communication I/F 7620 may connect to a terminal present in the vicinity of the vehicle (which terminal is, for example, a terminal of the driver, a pedestrian, or a store, or a machine type communication (MTC) terminal) using a peer to peer (P2P) technology, for example.

The dedicated communication I/F 7630 is a communication I/F that supports a communication protocol developed for use in vehicles. The dedicated communication I/F 7630 may implement a standard protocol such, for example, as wireless access in vehicle environment (WAVE), which is a combination of institute of electrical and electronic engineers (IEEE) 802.11p as a lower layer and IEEE 1609 as a higher layer, dedicated short range communications (DSRC), or a cellular communication protocol. The dedicated communication I/F 7630 typically carries out V2X communication as a concept including one or more of communication between a vehicle and a vehicle (Vehicle to Vehicle), communication between a road and a vehicle (Vehicle to Infrastructure), communication between a vehicle and a home (Vehicle to Home), and communication between a pedestrian and a vehicle (Vehicle to Pedestrian).

The positioning section 7640, for example, performs positioning by receiving a global navigation satellite system (GNSS) signal from a GNSS satellite (for example, a GPS signal from a global positioning system (GPS) satellite), and generates positional information including the latitude, longitude, and altitude of the vehicle. Incidentally, the positioning section 7640 may identify a current position by exchanging signals with a wireless access point, or may obtain the positional information from a terminal such as a mobile telephone, a personal handyphone system (PHS), or a smart phone that has a positioning function.

The beacon receiving section 7650, for example, receives a radio wave or an electromagnetic wave transmitted from a radio station installed on a road or the like, and thereby obtains information about the current position, congestion, a closed road, a necessary time, or the like. Incidentally, the function of the beacon receiving section 7650 may be included in the dedicated communication I/F 7630 described above.

The in-vehicle device I/F 7660 is a communication interface that mediates connection between the microcomputer 7610 and various in-vehicle devices 7760 present within the vehicle. The in-vehicle device I/F 7660 may establish wireless connection using a wireless communication protocol such as wireless LAN, Bluetooth (registered trademark), near field communication (NFC), or wireless universal serial bus (WUSB). In addition, the in-vehicle device I/F 7660 may establish wired connection by universal serial bus (USB), high-definition multimedia interface (HDMI (registered trademark)), mobile high-definition link (MHL), or the like via a connection terminal (and a cable if necessary) not depicted in the figures. The in-vehicle devices 7760 may, for example, include at least one of a mobile device and a wearable device possessed by an occupant and an information device carried into or attached to the vehicle. The in-vehicle devices 7760 may also include a navigation device that searches for a path to an arbitrary destination. The in-vehicle device I/F 7660 exchanges control signals or data signals with these in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various kinds of programs on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. For example, the microcomputer 7610 may calculate a control target value for the driving force generating device, the steering mechanism, or the braking device on the basis of the obtained information about the inside and outside of the vehicle, and output a control command to the driving system control unit 7100. For example, the microcomputer 7610 may perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automated driving, which makes the vehicle to travel automatedly without depending on the operation of the driver, or the like, by controlling the driving force generating device, the steering mechanism, the braking device, or the like on the basis of the obtained information about the surroundings of the vehicle.

The microcomputer 7610 may generate three-dimensional distance information between the vehicle and an object such as a surrounding structure, a person, or the like, and generate local map information including information about the surroundings of the current position of the vehicle, on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. In addition, the microcomputer 7610 may predict danger such as collision of the vehicle, approaching of a pedestrian or the like, an entry to a closed road, or the like on the basis of the obtained information, and generate a warning signal. The warning signal may, for example, be a signal for producing a warning sound or lighting a warning lamp.

The sound/image output section 7670 transmits an output signal of at least one of a sound and an image to an output device capable of visually or auditorily notifying information to an occupant of the vehicle or the outside of the vehicle. In the example of FIG. 12, an audio speaker 7710, a display section 7720, and an instrument panel 7730 are illustrated as the output device. The display section 7720 may, for example, include at least one of an on-board display and a head-up display. The display section 7720 may have an augmented reality (AR) display function. The output device may be other than these devices, and may be another device such as headphones, a wearable device such as an eyeglass type display worn by an occupant or the like, a projector, a lamp, or the like. In a case where the output device is a display device, the display device visually displays results obtained by various kinds of processing performed by the microcomputer 7610 or information received from another control unit in various forms such as text, an image, a table, a graph, or the like. In addition, in a case where the output device is an audio output device, the audio output device converts an audio signal constituted of reproduced audio data or sound data or the like into an analog signal, and auditorily outputs the analog signal.

Incidentally, at least two control units connected to each other via the communication network 7010 in the example depicted in FIG. 12 may be integrated into one control unit. Alternatively, each individual control unit may include multiple control units. Further, the vehicle control system 7000 may include another control unit not depicted in the figures. In addition, part or the whole of the functions performed by one of the control units in the above description may be assigned to another control unit. That is, predetermined arithmetic processing may be performed by any of the control units as long as information is transmitted and received via the communication network 7010. Similarly, a sensor or a device connected to one of the control units may be connected to another control unit, and multiple control units may mutually transmit and receive detection information via the communication network 7010.

In the vehicle control system 7000 described above, the distance measuring device according to the present disclosure is applicable, for example, to the outside-vehicle information detecting section.

### [Reference Signs List]

- 104:: Light-receiving element
- 105:: Replica
- 106:: Balun transformer
- 110:: Differential amplifier
- 111:: First comparator
- 112:: Second comparator
- 113:: Third comparator
- 123:: Third TDC
- 124:: Fourth TDC
- 125:: Demultiplexer
- 126:: FPGA
- 128:: Switch
- 1000:: Distance measuring device

## Claims

1. A distance measuring device comprising:
a light-receiving element that is able to achieve single-photon detection and that generates an analog output that varies with the number of simultaneously received photons;
an extraction section that extracts high-frequency components of an output of the light-receiving element;
an amplification section that amplifies an output of the extraction section; and
at least three comparators that receive supply of an output from the amplification section and have different threshold voltages,
wherein the threshold voltage set for a predetermined one of the comparators is a threshold voltage corresponding to single-photon detection in at least a part of a measurement period.

2. The distance measuring device according to claim 1, further comprising:
a time lag measuring section that is connected to a respective one of the comparators in order to determine a time lag according to an output of the respective comparator and to a reference signal; and
a distance calculation section that determines the number of photons corresponding to the time lag and a time walk error corresponding to the number of photons, corrects a provisional time lag based on the time lag by using the time walk error, and calculates a distance to a target according to a result of correction.

3. The distance measuring device according to claim 2, further comprising:
a demultiplexer connected to a comparator that is set to the threshold voltage corresponding to the single-photon detection; and
at least a first time lag measuring section and a second time lag measuring section that are connected to the demultiplexer.

4. The distance measuring device according to claim 3,
wherein the demultiplexer exercises control to supply a first output of the comparator in the measurement period to the first time lag measuring section, and supply a second output of the comparator to the second time lag measuring section, the second output being generated after the first output in the measurement period.

5. The distance measuring device according to claim 2,
wherein a switch is connected between the comparator set to the threshold voltage corresponding to the single-photon detection and the time lag measuring section connected to the comparator, and is controlled during a predetermined period to turn on from an off state.

6. The distance measuring device according to claim 5,
wherein the period during which the switch is on is changed according to intensity of external light.

7. The distance measuring device according to claim 2,
wherein the threshold voltage corresponding to the single-photon detection is set to a first threshold voltage at beginning of the measurement period and then switched to a second threshold voltage after a lapse of a predetermined time from the beginning of the measurement period, the single-photon detection being unachievable at the first threshold voltage and achievable at the second threshold voltage.

8. The distance measuring device according to claim 7,
wherein the threshold voltage corresponding to the single-photon detection continuously changes from the first threshold voltage to the second threshold voltage.

9. The distance measuring device according to claim 2,
wherein the single-photon detection becomes achievable at a predetermined timing when a baseline for the output of the extraction section rises from beginning of measurement.

10. The distance measuring device according to claim 2,
wherein a level of reliability is set for the time lag determined by each time lag measuring section, and at least either one of the time walk error and the provisional time lag is determined by using a weight on a basis of the level of reliability, and
the larger the minimum number of measurable photons, the higher the setting of the level of reliability.

11. The distance measuring device according to claim 1,
wherein the extraction section includes a balun transformer.

12. A vehicle-mounted device comprising:
a distance measuring device according to claim 1.
